Europäisches Patentamt

European Patent Office

Office européen des brevets

(19)

(11) Veröffentlichungsnummer: **0 118 673**
**B1**

(12) **EUROPÄISCHE PATENTSCHRIFT**

(45) Veröffentlichungstag der Patentschrift: **14.03.90**

(51) Int. Cl.⁵: **G 01 D 5/245, H 03 M 1/22**

(21) Anmeldenummer: **84100465.8**

(22) Anmeldetag: **18.01.84**

(54) **Messeinrichtung.**

(30) Priorität: **12.03.83 DE 3308814**

(43) Veröffentlichungstag der Anmeldung:
**19.09.84 Patentblatt 84/38**

(45) Bekanntmachung des Hinweises auf die
Patenterteilung:
**14.03.90 Patentblatt 90/11**

(84) Benannte Vertragsstaaten:
**AT CH DE FR GB IT LI NL SE**

(56) Entgegenhaltungen:
**EP-A-0 050 195
GB-A-2 067 282
US-A-3 982 106**

(73) Patentinhaber: **Dr. Johannes Heidenhain GmbH
Nansenstrasse 17
D-8225 Traunreut (DE)**

(72) Erfinder: **Schmitt, Walter, Ing. (grad.)
Hochgernstrasse 22
D-8225 Traunreut (DE)**

Courier Press, Leamington Spa, England.

**Beschreibung**

Die Erfindung betrifft eine Meßeinrichtung gemäß dem Oberbegriff des Anspruchs 1.

Bei einer derartigen Meßeinrichtung können die an den Referenzmarken erzeugten elektrischen Steuerimpulse auf verschiedene Weise verwertet werden, z.B. zum Reproduzieren der Nullposition im Zähler, zum Anfahren einer bestimmten Position zu Beginn der Messung un zur Kontrolle von Störimpulsen sowie zur Beaufschlagung einer nachgeschalteten Steuereinrichtung.

Aus der DE—PS 24 16 212 ist eine inkrementale Längen- oder Winkelmeßeinrichtung bekannt, bei der auf einem Maßstab neben der inkrementalen Teilung Referenzmarken auf einer gesonderten Spur vorgesehen sind. Die Absolutwerte dieser Referenzmarken bestimmen sich aus den unterschiedlichen Abständen zwischen den einzelnen Referenzmarken; diese Abstände zwischen den Referenzmarken werden durch Abtastung der inkrementalen Teilung ermittelt. Zur Erkennung der absoluten Position einer Referenzmarke müssen daher immer zwei Referensmarken abgetastet werden. Dieses Verfahren ist umständlich und zeitraubend, wenn beispielsweise zwei derartige Referenzmarken weit zueinander liegen. Zudem können bei einer fehlerhaften Zählung der Inkremente zwischen zwei Referenzmarken falsche Abstände und damit falsche Absolutwerte für die Referenzmarken ermittelt werden.

In der DE—PS 29 52 106 ist eine inkrementale Längen- oder Winkelmeßeinrichtung beschrieben, bei der auf einem Maßstab neben der Teilung Referenzmarken mit jeweils unterschiedlichen Strichgruppenverteilungen vorgesehen sind. Die einzelnen Referenzmarken werden von Abtastfeldern in einer Abtasteinheit abgetastet, wobei jedes Abtastfeld einer Referenzmarke eindeutig zugeordnet ist, indem es die gleiche Strichgruppenverteilung aufweist. Diese Anordnung ist relativ aufwendig, da die Strichgruppenverteilungen der einzelnen Referenzmarken sich möglichst stark voneinander unterscheiden müssen, um eine eindeutige Identifizierung der einzelnen Referenzmarken zu ermöglichen. Die Abtasteinheit muß dabei für jede Referenzmarke ein identisches Abtastfeld aufweisen.

Der DE—OS 30 39 483 auf der der Oberbegriff von Anspruch 1 beruht, entnimmt man eine inkrementale Längen- oder Winkelmeßeinrichtung, bei der auf einem Maßstab neben einer Teilungsspur parallel zueinander eine Referenzmarkenspur und eine Codemarkenspur angeordnet sind. Zur Abtastung der Referenzmarken und der jeweils zugehörigen Codemarkenteile sind aber gesonderte Abtastfelder auf einer Abtastplatte in einer Abtasteinheit erforderlich, wobei jedem Codemarkenteil ein eigenes Abtastfeld zugeordnet ist.

Der Erfindung liegt die Aufgabe zugrunde, eine Meßeinrichtung gemäß dem Oberbegriff des Anspruch 1 anzugeben, bei der die Abtastung der Referenzmarken und der jeweils zugehörigen Codemarkenteile wesentlich vereinfacht werden kann.

Diese Aufgabe wird erfindungsgemäß durch die kennzeichnenden Merkmale des Anspruchs 1 gelöst.

Die mit der Erfindung erzielten Vorteile bestehen insbesondere darin, daß zur Abtastung der Referenzmarken und der jeweils zugehörigen Codemarkenteile nur ein Abtastfeld auf der Abtastplatte der Abtasteinheit erforderlich ist, da die Referenzmarken und die Codemarkenteile zumindest in Meßrichtung die gleiche Struktur aufweisen. Durch diese strukturmäßige Übereinstimmung der Codemarkenteile mit den Referenzmarken wird die Herstellung des Maßstabes sowie der Abtastplatte wesentlich vereinfacht, so daß sich eine preisgünstigere Meßeinrichtung ergibt.

Vorteilhafte Weiterbildungen der Erfindung entnimmt man den abhängigen Ansprüchen.

Ausführungsbeispiele der Erfindung werden anhand der Zeichnung näher erläutert.

Es zeigen

Figur 1 schematisch eine inkrementale Längenmeßeinrichtung,

Figur 2 einen Meßstab und eine Abtastplatte der Längenmeßeinrichtung,

Figur 3 ein Signaldiagramm von Referenz- und Codesignalen und

Figur 4 einen Ausschnitt des Maßstabs nach Figur 2.

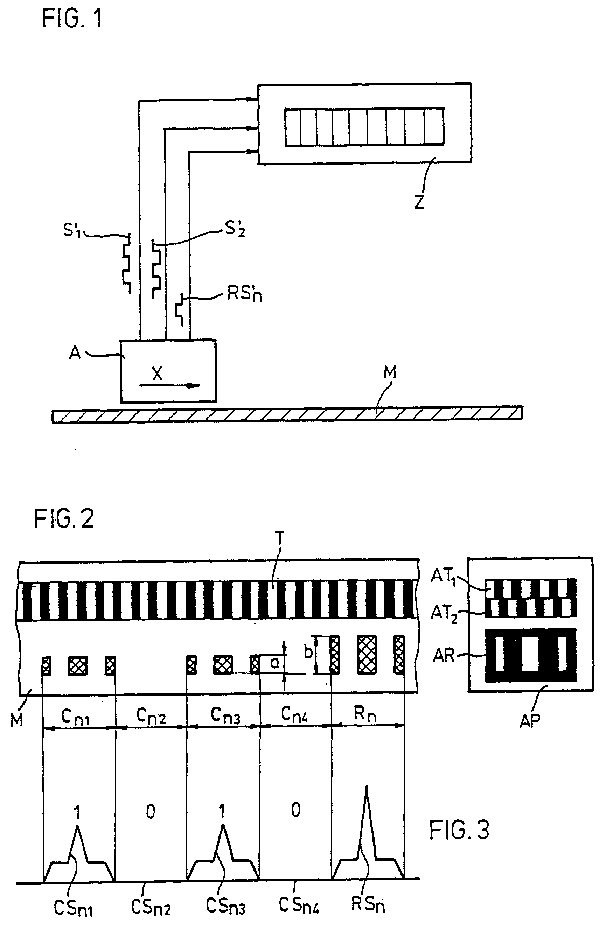

In Figur 1 ist schematisch eine lichtelektrische inkrementale Längenmeßeinrichtung gezeigt, die aus einem Maßstab M und aus einer Abtasteinheit A besteht, die jeweils in nicht dargestellter Weise mit zu messenden Objekten einer Bearbeitungsmaschine verbunden sind. Auf den Maßstab M ist eine inkrementale Teilung T in Form eines Strichgitters (Figur 2) aufgebracht, die im Auflicht photoelektrisch berührungsfrei von der Abtasteinheit A abgetastet wird. Entlang der Teilung T ist auf dem Maßstab M eine Reihe von Referenzmarken $R_n$ (n=1, 2, 3,...) vorgesehen, die jeweils identische Strichgruppen mit einer bestimmten Strichverteilung aufweisen. Die durch die Abtastung der Teilung T erzeugten periodischen Abtastsignale $S_1$, $S_2$, die in der Abtasteinheit A verstärkt und in Rechtecksignale $S_1'$, $S_2'$ umgeformt werden, steuern einen elektronischen Zähler Z, der die Meßwerte in digitaler Form anzeigt. Die um ein Viertel der Gitterkonstanten (Teilungsperiode) der Teilung T zueinander phasenverschobenen Rechtecksignale $S_1'$, $S_2'$ dienen der Diskriminierung der Abtastrichtung. Das an den Referenzmarken $R_n$ erzeugte Referenzsignal $RS_n$ wird in der Abtasteinheit A verstärkt, in ein Rechtecksignal $RS_n'$ umgeformt und ebenfalls dem Zähler Z zugeleitet.

Mit den gewonnenen Referenzsignalen $RS_n$ können verschiedene Funktionen ausgelöst werden. Durch Auswertung der Referenzsignale $RS_n$ wird beispielsweise aus einer inkrementalen Meßeinrichtung eine quasi absolute Meßeinrichtung, wenn jeder Referenzmarke $R_n$ eine Zahl zugeordnet wird, die deren absolute Position, bezogen auf einen unveränderlichen Nullpunkt, darstellt. Ferner kann eine bestimmte Referenz-

2

marke $R_n$ dazu dienen, den Zähler Z beim Auftreten des aus der bestimmten Referenzmarke $R_n$ gewonnenen Referenzsignals $RS_n$ auf den Wert "Null" zu setzen. Diese Funktionen sind aber nur ausführbar, wenn die ausgewählte Referenzmarke $R_n$ eindeutig identifiziert werden kann.

Zur Identifizierung ist jeder einzelnen Referenzmarke $R_n$ seriell eine Codemarke $C_n$ zugeordnet, die aus wenigstens einem Codemarkenteil $C_{nm}$ (n, m = 1, 2, 3,...) besteht, wobei jeder Codemarkenteil $C_{nm}$ wenigstens in Meßrichtung X strukturmäßig mit der Referenzmarke $R_n$ übereinstimmt.

Gemäß Figur 2 sind die Codemarkenteile $C_{nm}$ zwischen den einzelnen identischen Referenzmarken $R_n$ seriell zu den Referenzmarken $R_n$ auf dem Maßstab M angeordnet. Aus der Reihe von Referenzmarken $R_n$ ist nur eine Referenzmarke $R_n$ dargestellt, der die Codemarkenteile $C_{n1}$-$C_{n4}$ zugeordnet sind. Zur Unterscheidung der Codemarkenteile $C_{n1}$-$C_{n4}$ von der Referenzmarke $R_n$ ist die Breite a der Codemarkenteile $C_{n1}$-$C_{n4}$ senkrecht zur Meßrichtung X kleiner als die Breite b der Referenzmarke $R_n$; gemäß Figur 2 ist a=b/2.

Zur Abtastung des Maßstabs M ist in der Abtasteinheit A eine Abtastplatte AP nach Figur 2 vorgesehen, die zur Abtastung der Teilung T zwei um ein Viertel der Gitterkonstanten der Teilung T zueinander versetzte Abtastfelder $AT_1$, $AT_2$ aufweist, die mit der Teilung T identisch sind; den Abtastfeldern $AT_1$, $AT_2$ sind nicht gezeigte Photoelemente zur Erzeugung der Abtastsignale $S_1$, $S_2$ zugeordnet. Zur Abtastung der Referenzmarke $R_n$ und der Codemarkenteile $C_{n1}$-$C_{n4}$ ist auf der Abtastplatte AP ein Abtastfeld AR vorgesehen, dem ein nicht dargestelltes Photoelement zur Erzeugung des Referenzsignals $RS_n$ und von Codesignalen $CS_{n1}$-$CS_{n4}$ zugeordnet ist; das Abtastfeld AR stimmt mit der Referenzmarke $R_n$ überein.

Die bei der Abtastung des Maßstabs M gemäß Figur 2 von links nach rechts erzeugten Codesignale $CS_{n1}$-$CS_{n4}$ ergeben die Binärkombination "1010" zur eindeutigen Identifizierung der zugehörigen Referenzmarke $R_n$ (Figur 3). Da die Breite b der Referenzmarke $R_n$ doppelt so groß wie die Breite a der Codemarkenteile $C_{n1}$-$C_{n4}$ ist, können die Codesignale $CS_{n1}$-$CS_{n4}$ eindeutig vom Referenzsignal $RS_n$ aufgrund der unterschiedlichen Signalhöhen unterschieden werden; das Verhältnis zwischen den Breiten a und b kann beliebig gewählt werden. Die Codesignale $CS_{n1}$-$CS_{n4}$ werden einer Auswerteeinrichtung im Zähler Z zugeleitet.

Wenn die Abtasteinheit A den Maßstab M in positiver Meßrichtung X von links nach rechts abtastet, so folgen auf die Referenzmarke $R_n$ die nächsten Codemarkenteile $C_{n+1, m}$ und darauf die zugehörige Referenzmarke $R_{n+1}$ etc. (in der Figur 2 nicht dargestellt). Um bei dieser Abtastrichtung den ersten Codemarkenteil $C_{n+1, 1}$ erkennen zu können, sollte dieser Codemarkenteil $C_{n+1, 1}$ beispielsweise den Binärwert "1" besitzen. Ganz allgemein können die Codemarkenteile $C_{nm}$ Anfangs- und Endinformationen aufweisen. Mit der Anfangsinformation kann die Auswertein-

richtung im Zähler Z darauf vorbereitet werden, daß in Anschluß an die Anfangsinformation eine Codeinformation ausgelesen wird. Die Endinformation dient zur Sicherstellung, daß die gesamte Codeinformation ausgelesen wurde; dadurch kann eine eventuelle Umkehrung der Meßrichtung X mitten in der Abtastung der Codeinformation erkannt werden.

Bei der Bewegung der Abtasteinheit A in positiver Meßrichtung X von links nach rechts erfolgt die Abtastung der Codeinformation der Codemarkenteils $C_{nm}$ vor der Abtastung der zugehörigen Referenzmarke $R_n$. Bei der Abtastbewegung in negativer Meßrichtung −X von rechts nach links wird durch die richtungsabhängige Auswertung der Codeinformationen erkannt, daß nach den Codemarkenteilen $C_{n+1, m}$ die Referenzmarke $R_n$ folgen muß.

Die Codemarkenteile $C_{nm}$ und die zugehörige Referenzmarke $R_n$ können lückenlos aufeinander folgen oder einen bestimmten Abstand untereinander aufweisen. Die lückenlose Anordnung empfiehlt sich, wenn zwischen den einzelnen Referenzmarken $R_n$ nur wenig Raum vorhanden ist. Zweckmäßig werden die Codemarkenteile $C_{nm}$ und die Referenzmarken $R_n$ als ganzzahliger Teil und/oder als ganzzahliges Vielfache der Teilungsperiode der Inkrementalteilung T auf dem Maßstab M aufgebracht, so daß die Abtastung der Codemarkenteile $C_{nm}$ und der Referenzmarken $R_n$ im Takt der Abtastung der Inkrementalteilung T erfolgt.

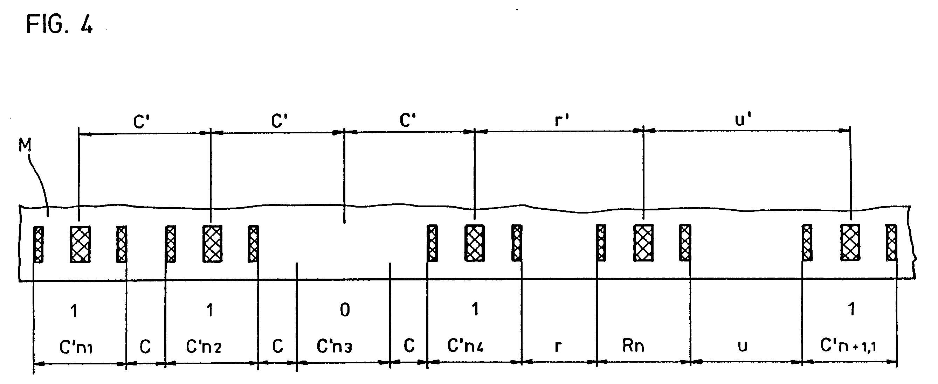

Nach Figur 4 sind auf einem vergrößerten Ausschnitt des Maßstabs M gemäß Figur 2 eine Referenzmarke $R_n$ sowie die zugehörigen Codemarkenteile $C'_{n1}$-$C'_{n4}$ und der erste Codemarkenteil $C'_{n+1, 1}$ der in positiver Meßrichtung X folgenden nicht gezeigten Referenzmarke $R_{n+1}$ serielle angeordnet. Die Codemarkenteile $C'_{n1}$-$C'_{n4}$ und $C'_{n+1, 1}$ sind völlig identisch mit der Referenzmarke $R_n$ und werden vom Abtastfeld AR der Abtastplatte AP gemäß Figur 2 abgetastet.

Zur Unterscheidung der Referenzmarke $R_n$ von den zugehörigen Codemarkenteilen $C'_{n1}$-$C'_{n4}$ unterscheidet sich der Abstand r zwischen der Referenzmarke $R_n$ und dem nächstliegenden Codemarkenteil $C'_{n4}$ vom Abstand c zwischen den einzelnen benachbarten Codemarkenteilen $C'_{n1}$-$C'_{n4}$. Zur Unterscheidung der Referenzmarke $R_n$ von dem in positiver Meßrichtung X folgenden, nicht zugehörigen Codemarkenteil $C'_{n+1,1}$ ist der gegenseitige Abstand u vorgesehen. Die erzeugten Codesignale $CS'_{n1}$-$CS'_{n4}$ ergeben die Binärkombination "1101".

Zur Unterscheidung können anstelle der Abstände c, r, u auch die entsprechenden Abstände c', r', u' zwischen den Schwerpunkten (Mitten) der Referenzmarke $R_n$ und den Codemarkenteilen $C'_{nm}$ herangezogen werden. Die Referenzmarke $R_n$ und die Codemarkenteile $C'_{nm}$ sowie die Abstände c, r, u, c', r', u' in Meßrichtung X können wiederum als ganzzahlige Teile und/oder als ganzzahlige Vielfache der Teilungsperiode der Inkrementalteilung T auf dem Maßstab M ausgebildet sein.

Die Auswertung der erzeugten Codesignale $CS_{nm}$ sowie der Abstände c, r, u, c', r', u' erfolgt in der Auswerteeinrichtung das Zählers Z. Diese Auswerteeinrichtung kann eine Auswahleinrichtung enthalten, mit deren Hilfe bestimmte Referenzmarken $R_n$ aus der Reihe der Referenzmarken $R_n$ ausgewählt und zur Wirkung gebracht werden können.

**Patentansprüche**

1. Inkrementale Meßeinrichtung mit entlang der Teilung eines Maßstabs in Meßrichtung vorgesehenen identischen Referenzmarken sowie den Referenzmarken zugeordneten und von den Referenzmarken unterscheidbaren Codemarken, die aus wenigstens einem Codemarkenteil bestehen; bei der die Referenzmarken zusammen mit den jeweils zugeordneten Codemarken der Teilung absolut zugeordnet sind, und bei der an den Referenzmarken im Zusammenwirken mit einer Abtasteinheit reproduzierbare elektrische Impulse erzeugt werden, die einen Zähler der Meßeinrichtung und/oder eine Steuereinrichtung beaufschlagen, dadurch gekennzeichnet, daß jede Codemarke ($C_n$) seriell zur entsprechenden Referenzmarke ($R_n$) angeordnet ist und daß jeder Codemarkenteil ($C_{nm}$, n, m=1, 2...) wenigstens in Meßrichtung X in seiner Abtaststruktur mit der Referenzmarke ($R_n$) übereinstimmt.

2. Meßeinrichtung nach Anspruch 1, dadurch gekennzeichnet, daß zur seriellen Abtastung der Referenzmarken ($R_n$) und der Codemarkenteile ($C_{nm}$) ein einziges Abtastfeld (AR) auf einer Abtastplatte (AP) vorgesehen ist.

3. Meßeinrichtung nach Anspruch 1, dadurch gekennzeichnet, daß zur Unterscheidung der Codemarkenteile ($C_{nm}$) von der Referenzmarke ($R_n$) die Breite a der Codemarkenteile ($C_{nm}$) senkrecht zur Meßrichtung X kleiner als die Breite b der Referenzmarke ($R_n$) ist.

4. Meßeinrichtung nach Anspruch 1, dadurch gekennzeichnet, daß zur Unterscheidung der Referenzmarke ($R_n$) von den zugehörigen Codemarkenteilen ($C'_{nm}$) der Abstand r zwischen der Referenzmarke ($R_n$) und dem nächstliegenden zugehörigen Codemarkenteil ($C'_{nm}$) sich vom Abstand c zwischen benachbarten zugehörigen Codemarkenteilen ($C'_{nm}$, $C'_{n, m+1}$ bzw. $C'_{nm}$, $C'_{n, m-1}$) unterscheidet.

5. Meßeinrichtung nach Anspruch 1, dadurch gekennzeichnet, daß zur Unterscheidung der Referenzmarke ($R_n$) von dem nächstliegenden zugehörigen Codemarkenteil ($C'_{nm}$) und von dem nächstliegenden nichtzugehörigen Codemarkenteil ($C'_{n+1, 1}$) der Abstand r zwischen der Referenzmarke ($R_n$) und dem nächstliegenden zugehörigen Codemarkenteil ($C'_{nm}$) sich vom Abstand u zwischen der Referenzmarke ($R_n$) und dem nächstliegenden nichtzugehörigen Codemarkenteil ($C'_{n+1, 1}$) unterscheidet.

6. Meßeinrichtung nach Anspruch 1, dadurch gekennzeichnet, daß die Codemarkenteile ($C_{nm}$) außer den Identifizierungsmerkmalen für die zugehörige Referenzmarke ($R_n$) noch Informationen zur Vollständigkeitserkennung aufweisen.

7. Meßeinrichtung nach Anspruch 1, dadurch gekennzeichnet, daß die Codemarkenteile ($C_{nm}$) und die Referenzmarke ($R_n$) sowie die Abstände c, r, u in Meßrichtung X als ganzzahliger Teil und/oder als ganzzahliges Vielfaches der Teilungsperiode der Teilung (T) des Meßstabs (M) ausgebildet sind.

**Revendications**

1. Dispositif de mesure incrémentale comprenant des marques de référence identiques prévues dans la dierction de mesure le long de la graduation d'une règle de mesure, ainsi que des marques codées qui sont associées aux marques de référence, peuvent être différenciées des marques de référence et comprennent au moins une partie de marque codée; dans lequel les marques de référence, conjointement avec les marques codées associées, sont associées de manière absolue à la graduation et dans lequel des impulsions électriques reproductibles appliquées à un compteur du dispositif de mesure et/ou à un dispositif de commande sont produites sur les marques de référence, en coopération avec une unité d'exploration, caractérisé par le fait que chaque marque codée ($C_n$) est associée de manière sérielle à la marque de référence correspondante ($R_n$) et que chaque partie de marque codée ($C_{nm}$, n,m=1, 2...) coïcide, au moins dans la direction de mesure X, avec la marque de référence ($R_n$) dans sa structure d'exploration.

2. Dispositif de mesure suivant la revendication 1 caractérisé par le fait qu'en vue de l'exploration sérielle des marques de référence ($R_n$) et des parties de marque codée ($C_{nm}$), un unique champs d'exploration (AR) est prévu sur une plaque d'exploration (AP).

3. Dispositif de mesure suivant la revendication 1 caractérisé par le fait qu'en vue de la différenciation des parties de marque codée ($C_{nm}$) par rapport à la marque de référence ($R_n$), la largeur a des parties de marque codée ($C_{nm}$) perpendiculairement à la direction de mesure (X) est inférieure à la largeur b de la marque de référence ($R_n$).

4. Dispositif de mesure suivant la revendication 1, caractérisé par le fait qu'en vue de la différenciation de la marque de référence ($R_n$) par rapport aux parties de marque codée associées ($C'_{nm}$), la distance r entre la marque de référence ($R_n$) et la partie de marque codée ($C'_{nm}$) associée la plus proche diffère de la distance c entre les parties de marque codée ($C'_{nm}$, $C'_{n, m+1}$ et $C'_{nm}$, $C'_{n, m-1}$) associées voisines.

5. Dispositif de mesure suivant la revendication 1, caractérisé par le fait qu'en vue de la différenciation de la marque de référence ($R_n$) par rapport à la partie de marque codée ($C'_{nm}$) associée la plus proche et par rapport à la partie de marque codée ($C'_{n+1, 1}$) non associée la plus proche, la distance r entre la marque de réfé-

rence ($R_n$) et la partie de marque codée ($C'_{nm}$) associée la plus proche diffère de la distance u entre la marque de référence ($R_n$) et la partie de marque codée ($C'_{n+1, 1}$) non associée la plus proche.

6. Dispositif de mesure suivant la revendication 1, caractérisé par le fait que les parties de marque codée ($C_{nm}$) présentent, outre les caractéristiques d'identification pour la marque de référence ($R_n$) associée, encore des informations pour la reconnaissance d'intégralité.

7. Dispositif de mesure suivant la revendication 1, caractérisé par le fait que les parties de marque codée ($C_{nm}$) et la marque de référence ($R_n$) ainsi que les distances c, r, u dans la direction de mesure X sont établies en tant que fraction entière et/ou en tant que multiple entier de la période de la graduation (T) de la règle de mesure (M).

**Claims**

1. Incremental measuring device with identical reference marks provided along the graduation of a measuring scale in the measuring direction, as well as code marks associated with the reference marks and distinguishable from the reference marks, which code marks consist of at least one code mark part; in which the reference marks together with the respective associated code marks are absolutely associated with the graduation, and in which reproducible electric pulses are generated at the reference marks in cooperation with a sensing unit, which pulses affect a counter of the measuring device and/or a control device, characterized in that each code mark ($C_n$) is serially associated with the corresponding reference mark ($R_n$) and each code mark part ($C_{nm}$, n,m=1,2...) conforms in its sensing structure at least in the measuring direction X with the reference mark ($R_n$).

2. Measuring device according to claim 1, characterized in that a single sensing field (AR) is provided on a sensing plate (AP) for the serial sensing of the reference marks ($R_n$) and the code mark parts ($C_{nm}$).

3. Measuring device according to claim 1, characterized in that the width a of the code mark parts ($C_{nm}$) perpendicular to the measuring direction X is smaller than the width b of the reference mark ($R_n$), for distinguishing the code mark parts ($C_{nm}$) from the reference mark ($R_n$).

4. Measuring device according to claim 1, characterized in that the distance r between the reference mark ($R_n$) and the next adjacent associated code mark parts ($C'_{nm}$) differs from the distance c between neighbouring associated code mark part ($C'_{nm}$, $C'_{n, m+1}$ or $C'_{nm}$, $C'_{n, m-1}$), for distinguishing the reference mark ($R_n$) from the associated code mark parts ($C'_{nm}$).

5. Measuring device according to claim 1, characterized in that the distance r between the reference mark ($R_n$) and the next adjacent associated code mark part ($C'_{nm}$) differs from the distance u between the reference mark ($R_n$) and the next adjacent non-associated code mark part ($C'_{n+1, 1}$), for distinguishing the reference mark ($R_n$) from the next adjacent associated code mark part ($C'_{nm}$) and from the next adjacent non-associated code mark part ($C'_{n+1, 1}$).

6. Measuring device according to claim 1, characterized in that the code mark parts ($C_{nm}$) comprise information for recognition of completeness apart from the identifying features for the associated reference mark ($R_n$).

7. Measuring device according to claim 1, characterized in that the code mark parts ($C_{nm}$) and the reference mark ($R_n$) as well as the distances c, r, u in the measuring direction X are formed as integral fractions and/or as integral multiples of the graduation period of the graduation (T) of the measuring scale (M).

FIG. 1

FIG. 2

FIG. 3

FIG. 4

M

| C' | C' | C' | r' | u' |

| 1 | 1 | 0 | 1 | | 1 |
| $C'_{n1}$ | C | $C'_{n2}$ | C | $C'_{n3}$ | C | $C'_{n4}$ | r | $R_n$ | u | $C'_{n+1,1}$ |